# EUROPÄISCHE PATENTSCHRIFT

(11) **EP 0 467 081 B1**
(45) Veröffentlichungstag und Bekanntmachung des Hinweises auf die Patenterteilung: **04.06.1997**
(21) Anmeldenummer: 91109976.0
(22) Anmeldetag: 18.06.1991
(51) Int. Cl.: H01L 21/331, H01L 21/3205, H01L 21/3215, H01L 21/285

(54) **Verfahren zur Herstellung eines Bipolartransistors**
Method of manufacturing a bipolar transistor
Procédé pour fabriquer un transistor bipolaire

(30) Priorität: 18.07.1990 DE 4022892
(43) Veröffentlichungstag der Anmeldung: 22.01.1992
(73) Patentinhaber: SIEMENS AKTIENGESELLSCHAFT, 80333 München (DE)
(72) Erfinder: Bertagnolli, Emmerich, Dr, W-8000 München 40 (DE)

(56) Entgegenhaltungen:
- EP-A- 0 118 102
- US-A- 4 997 776
- INTERNATIONAL ELECTRON DEVICES MEETING, Dezember 1983, Seiten 27-30; T. SHIBATA et al.: 'A simplified box (buried-oxide) isolation technology for megabit dynamic memories'
- HALBLEITER-ELEKTRONIK 19, 1988, Springer Verlag, Seiten 293-297; D. WIDMANN et al.: 'Technologie hochintegrieter Schaltungen'
- IEEE TRANSACTIONS ON ELECTRON DEVICES, Band ED-28, Nr. 7, Juli 1981, Seiten 1010-1013; T.H. NING et al.: 'Self-aligned bipolar transistors for high-performance and low-power-delay VLSI'
- IEEE TRANSACTIONS ON ELECTRON DEVICES, Band ED-34, Nr. 8, August 1987, Seiten 338-340; G.P. LI et al.: 'Bipolar transistor with self-aligned lateral profile'

## Beschreibung

Die Erfindung betrifft ein Verfahren zur Herstellung eines Bipolartransistors.

Es ist bekannt, in einem Substrat integrierte Bipolartransistoren in selbstjustierten Doppelpolysiliziumprozessen herzustellen (s. z. B. T. H. Ning et al, IEEE Trans. on Electron. Devices ED-28 (1981) S. 1010 ff; G.P. Li et al, IEEE Electron. Device Lett EDL-8 (1987) S. 338 ff.). Dabei werden auf das Substrat zwei Polysiliziumschichten nacheinander aufgebracht, die entgegengesetzt zueinander dotiert sind. Aus der einen Polysiliziumschicht entsteht ein Basisanschluß, aus der anderen Emitteranschluß und Kollektoranschluß. Die beiden Polysiliziumschichten sind voneinander durch sogenannte Oxid-Spacer getrennt. Ein Oxid-Spacer ist eine isolierende Kantenbedeckung, die entweder an dem fertigen Basisanschluß vor Aufbringen der zweiten Polysiliziumschicht erzeugt wird, oder die an dem fertigen Emitteranschluß vor dem Aufbringen der Polysiliziumschicht für den Basisanschluß erzeugt wird. Auf diese Weise wird der Abstand zwischen Basisanschluß und Emitteranschluß unabhängig von der verwendeten Photolithographie.

Die sich ergebenden Transistoren weisen eine sehr unebene Topographie auf, was in hochintegrierten Schaltungen einen Nachteil darstellt.

Bei der Strukturierung der ersten Polysiliziumschicht sowie bei der Spacer-Bildung sind Überätzschritte notwendig, die die Substratoberfläche abtragen und zu einem Verlust der Referenzebene führen. Dieses hat Anschlußprobleme zur Folge.

Bei der Herstellung eines Bipolartransistors mit Oxidspacern an den Flanken des Basisanschlusses ist sowohl bei der Strukturierung der ersten Polysiliziumschicht als auch bei der Spacerbildung ein Plasma unterstütztes Ätzen der späteren Emittergrenzfläche erforderlich. Dieses führt zu Ausbeuterisiken.

Transistoren mit Oxidspacern an den Flanken der Basisanschlüsse sind in ihrer Herstellung nicht kompatibel mit fortgeschrittenen Techniken wie z. B. abgeschiedenen Homo- oder Heterobasen oder abgeschiedenen Heteroemittern.

Bei der Herstellvariante, bei der die Oxidspacer die Flanken des zunächst hergestellten Emitteranschlusses bedecken ist es unmöglich, selbstjustiert einen sogenannten Podest-Kollektor zu implementieren. Der Podest-Kollektor besteht in einer zusätzlichen Implantation des Kollektors im aktiven Transistorbereich (s. K. Ehinger et al, ESSDERC'89, pp. 797, Springer 1989).

Ein weiterer Nachteil der bekannten Herstellverfahren ist darin zu sehen, daß es Schwierigkeiten gibt, für beide siliziumschichten Silizidtechniken einzuführen. Bei der Einführung von Silizidtechniken muß in jedem Fall ein Silizid einen Hochtemperaturschritt aushalten können, ohne die Bauelementeigenschaften zu schädigen. In der Variante, daß zunächst der Basisanschluß hergestellt und mit Oxidspacern bedeckt wird, muß das Silizid des Basisanschlusses einen austreibschritt unbeschadet überstehen. In der Variante, daß zunächst der Emitteranschluß hergestellt und mit Spacern versehen wird, muß das Silizid des Emitteranschlusses die Temperaturschritte bei der Herstellung des Basisanschlusses überstehen.

Der Erfindung liegt die Aufgabe zugrunde, ein Verfahren zur Herstellung planarer Bipolartransistoren anzugeben, bei dem Ausbeuterisiken durch Ätzplasmenbelastung reduziert werden und das kompatibel mit fortgeschrittenen Herstelltechniken ist.

Diese Aufgabe wird erfindungsgemäß gelöst durch ein Verfahren zur Herstellung eines Bipolartransistors nach Anspruch 1.

Da in dem erfindungsgemäßen Herstellverfahren Basisanschluß, Emitteranschluß und Kollektoranschluß aus einer einzigen Schicht aus z. B. Polysilizium erzeugt werden, werden die im Stand der Technik unvermeidlichen Unebenheiten durch Überlappungen zweier Polysiliziumschichten und einer beide Schichten isolierenden Oxidschicht vermieden. Der nach dem erfindungsgemäßen Herstellverfahren erzeugte Bipolartransistor weist eine planare Oberfläche auf.

Da der Basisanschluß, der Emitteranschluß und der Kollektoranschluß gleichzeitig in einem Ätzschritt aus der planaren Schicht erzeugt werden, entfällt eine Ätzplasmenbelastung und die damit verbundenen Ausbeuterisiken im Bereich für den Emitter.

In dem erfindungsgemäßen Herstellverfahren sind keinerlei Einschränkungen für die Erzeugung eines Basisbereichs in dem Substrat gegeben. Je nach Vorgabe für den fertigen Bipolartransistor wird die Dotierstoffkonzentration im Substrat für den aktiven Basisbereich durch Implantation, Diffusion oder epitaktische Abscheidung erzeugt. Die Implantation erfolgt vor der Erzeugung der planaren Schicht. Die epitaktische Abscheidung erfolgt ebenfalls vor Erzeugung der planaren Schicht. Dabei wird z. B. auf ein Substrat aus Silizium eine Schicht von z. B. 50 nm Dicke aus Si oder aus Si₁₋ₓGeₓ (x = 0,1 bis 0,3) für die Basis und eine 50 nm dicke Schicht aus Si oder Si₁₋ₓGeₓ (x = 0,1 bis 0,3) für den Emitter abgeschieden. Bei Erzeugung der Basisdotierung durch Diffusion erfolgt diese aus der planaren Schicht.

Unter Verwendung der ersten Hilfsstruktur als Implantationsmaske ist es möglich, durch eine zusätzliche, hochenergetische Implantation von Dotierstoff des zweiten Leitfähigkeitstyps einen Podest-Kollektor unterhalb des Emitters zu erzeugen.

Es liegt im Rahmen der Erfindung, zur selbstjustierten Herstellung der zweiten Hilfsstruktur auf die erste Hilfsstruktur und die freiliegenden Bereiche der planaren Schicht ganzflächig und konform eine erste Hilfsschicht abzuscheiden. Die erste Hilfsschicht ist selektiv zur ersten Hilfsstruktur und zur planaren Schicht ätzbar. Die Dicke der ersten Hilfsschicht wird so bestimmt, daß die Oberfläche der ersten Hilfsschicht Vertiefungen aufweist, die die Form der ersten Hilfsstruktur wiederspiegeln. Auf der ersten Hilfsschicht wird eine zweite Hilfsschicht erzeugt, die selektiv zur ersten Hilfsschicht ätzbar ist. Die zweite Hilfsschicht bedeckt die Oberfläche der ersten Hilfsschicht vollständig und füllt die Vertiefungen in der Oberfläche der ersten Hilfsschicht vollständig auf. Die zweite Hilfsschicht besteht z. B. aus einer planarisierenden Phosphor-Bor-Silikat-Glasschicht oder aus einer konform abgeschiedenen Siliziumoxidschicht. Durch Rückätzen der zweiten Hilfsschicht bis zum Freilegen der Oberfläche der ersten Hilfsschicht außerhalb der Vertiefungen und durch anschließendes Rückätzen der freiliegenden Teile der ersten Hilfsschicht bis auf die darunterliegende Oberfläche der planaren Schicht wird die zweite Hilfsstruktur erzeugt. Die Breite der zwischen der ersten Hilfsstruktur und der zweiten Hilfsstruktur gebildeten Spalte wird durch die Dicke festgelegt, in der die erste Hilfsschicht abgeschieden wird. Da die Abscheidung von Schichten der Dicke 20 - 500 nm genau kontrollierbar ist, werden Abstände dieser Breite erzielt.

Weitere Ausgestaltungen der Erfindung gehen aus den übrigen Ansprüchen hervor.

Im folgenden wird die Erfindung anhand eines Ausführungsbeispiels der Figuren näher erläutert.
- Fig. 1 bis Fig. 12: zeigen die einzelnen Schritte bei der erfindungsgemäßen Herstellung eines Bipolartransistors.
- Fig. 13: zeigt einen fertigen, nach dem erfindungsgemäßen Verfahren hergestellten Bipolartransistor.
- Fig. 14 und 15: zeigen einen nach dem erfindungsgemäßen Verfahren hergestellten Bipolartransistor nach Silizierung von Basis-, Emitter- und Kollektoranschluß.

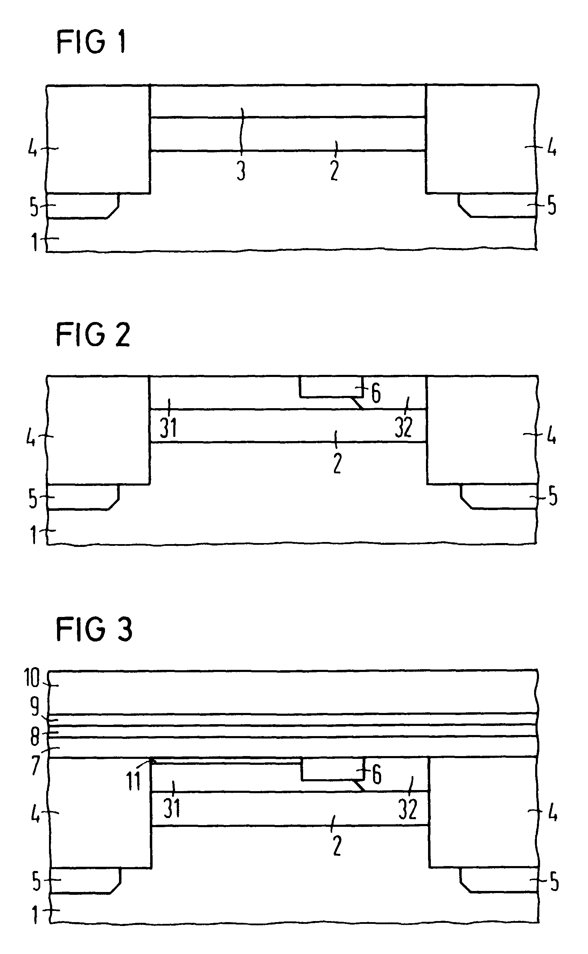

Die in Fig. 1 dargestellte Struktur wird durch folgende Prozeßschritte hergestellt: in einem Substrat 1 aus einkristallinem, p-dotiertem Silizium wird ein vergrabener Kollektor 2 z. B. durch Implantation von n-dotierenden Ionen erzeugt. Im nächsten Schritt wird ganzflächig eine n-dotierte Epitaxieschicht 3 aufgebracht. Zur Trennung benachbarter Transistoren im Substrat 1 werden Isolationsbereiche 4 und Channel stopper-Bereiche 5 hergestellt. Dazu werden nach Erzeugung einer Photolackmaske Isolationswannen durch anisotrope Ätzung hergestellt. Die Isolationswannen reichen z. B. 100 bis 500 nm tiefer in das Substrat 1 hinein als der vergrabene Kollektor 2. Durch Implantation mit n-dotierenden Ionen werden die Channel stopper-Bereiche 5 hergestellt. Schließlich werden die Isolationsbereiche 4 durch Auffüllung der Isolationswannen in einem CVD-Oxid erzeugt. Falls erforderlich wird die Oberfläche durch eine Rückätzung planarisiert. Diese Isolationsvariante, die BOX-Isolation genannt wird, ist z. B. in T. Shibata et al, IEDM Techn. Dig. 1983, S. 27 - 30 beschrieben.

Die Herstellung des vergrabenen Kollektors 2, der Epitaxieschicht 3, der Isolationsbereiche 4 und der Channel stopper-Bereiche 5 kann abgesehen von der hier beschriebenen Box-Isolationstechnik auch mit Hilfe der sogenannten Recessed-Oxide-Technik, die z. B. in D. Widmann et al, Technologie hochintegrierter Schaltungen, Reihe Halbleiter Elektronik Bd. 19, Springer 1988, S. 293-297 beschrieben wird, oder mit Hilfe einer Trench-Isolations-Technik, wie sie z. B. in L. Treitinger et al, Ultrafast Silicon Bipolar Technology, Springer Series in Electronics and Photonics 27, Springer 1988 beschrieben wird, erfolgen.

Es wird eine Oxidinsel 6 in der Epitaxieschicht 3 hergestellt (s. Fig. 2), die die Epitaxieschicht 3 in eine Epitaxieinsel 31 zur Aufnahme des späteren Emitter/Basis-Bereichs und in einen Kollektoranschlußbereich 32 unterteilt. Der Kollektoranschlußbereich 32 wird nach entsprechender Maskierung der übrigen Bereiche z. B. durch Ionenimplantation und anschließende Diffusion mit n-dotierenden Ionen erzeugt.

Auf die Oberfläche der Isolationsbereiche 4, der Epitaxieinsel 31, der Oxidinsel 6 und des Kollektoranschlußbereiches 32 wird ganzflächig eine planare Schicht 7 aufgebracht (s. Fig. 3). Die planare Schicht 7 ist elektrisch leitfähig und von einem ersten Leitfähigkeitstyp, z. B. p-dotiert. Die planare Schicht 7 besteht z. B. aus Polysilizium. Sie wird z. B. in einem CVD-Verfahren amorph oder kristallin in einer Dicke von 200 nm abgeschieden. Die Dotierung erfolgt entweder in situ während der Abscheidung oder nach der Abscheidung durch Implantation von z. B. Bor mit einer Dosis von 8 x 10¹⁵ cm⁻² und einer Energie von 10 keV.

Auf die planare Schicht 7 (s. Fig. 3) wird eine erste Schicht 8 aufgebracht, die selektiv zur planaren Schicht 7 ätzbar ist. Die erste Schicht 8 besteht z. B. aus Siliziumoxid und weist eine Dicke von z. B. 50 nm auf. Auf die erste Schicht 8 wird eine zweite Schicht 9 aufgebracht, die wiederum selektiv zur ersten Schicht 8 ätzbar ist. Die zweite Schicht 9 besteht z. B. aus Polysilizium und weist eine Dicke von z. B. 50 nm auf. Auf die zweite Schicht 9 wird eine dritte Schicht 10 abgeschieden, die selektiv zur zweiten Schicht 9 ätzbar ist. Die dritte Schicht 10 besteht z. B. aus Siliziumoxid und weist eine Dicke von z. B. 200 nm auf.

An der Oberfläche der Epitaxieinsel 31 wird eine Basiszone 11 z. B. durch Ausdiffusion aus der planaren Schicht 7 erzeugt. Im Bereich des Kollektoranschlußbereichs 32 wird die aus der planaren Schicht 7 ausdiffundierte Dotierung durch die entgegengesetzte, höhere Dotierung des Kollektoranschlußbereichs 32 kompensiert.

Andere Möglichkeiten zur Herstellung der Basiszone 11 bestehen darin, daß vor Abscheidung der planaren Schicht 7 nach entsprechender Maskierung eine Implantation von z. B. Bor mit einer Dosis von 2,8 x 10¹³ cm⁻² und einer Energie von 5 keV vorgenommen wird. Eine weitere Möglichkeit zur Herstellung der Basiszone 11 besteht in einer epitaktischen Abscheidung der Basis vor Erzeugung der planaren Schicht 7 und einer anschließenden epitaktischen Abscheidung einer Emitterzone ebenfalls vor Erzeugung der planaren Schicht 7. Dabei ist es möglich Homojunction-Transistoren mit z. B. 50 nm Bor dotierter Basis und 50 nm Emitter oder einen Heterojunction-Transistor mit z. B. 50 nm Si₁₋ₓGeₓ (x = 0,1 bis 0,3) für die Basis und 50 nm Si für den Emitter abzuscheiden. Es ist ebenso möglich einen Transistor mit einer Homojunction-Basis und einen Heterojunction-Emitter oder Heterojunction-Basis und Heterojunction-Emitter herzustellen.

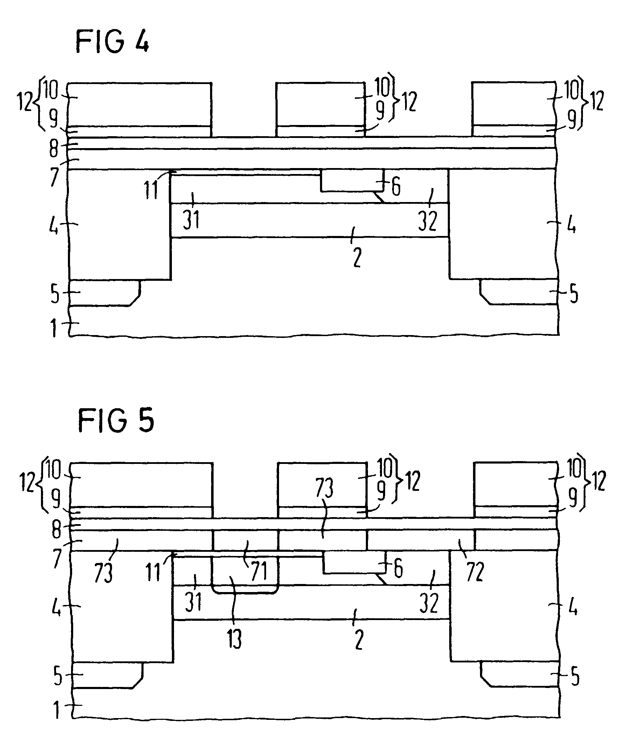

Es wird eine Photolackmaske erzeugt, die diejenigen Bereiche der dritten Schicht 10 abdeckt, unterhalb denen Basisanschlüsse vorgesehen sind, während sie diejenigen Bereiche der Oberfläche der dritten Schicht 10 freiläßt, unterhalb der ein Emitteranschluß und ein Kollektoranschluß vorgesehen sind. Durch eine anisotrope Ätzung, z. B. durch reaktives Ionenätzen mit CHF₃/O₂ wird die dritte Schicht 10 aus Siliziumoxid entsprechend der Photolackmaske strukturiert. Dabei wirkt die zweite Schicht 9 als Ätzstopp. Nach Abschluß der Ätzung und, falls erforderlich, einer geeigneten Nachbehandlung zur Entfernung eventueller Ätzpolymere wird die Photolackmaske entfernt (s. Fig. 4).

Anschließend wird die zweite Schicht 9 durch eine anisotrope Ätzung, z. B. durch reaktives Ionenätzen mit BCl₃/Cl₂ strukturiert. Bei der Strukturierung der zweiten Schicht 9 kann auch gleichzeitig die Photolackmaske entfernt werden. Bei der Strukturierung der zweiten Schicht 9 dient die darunterliegende erste Schicht 8 als Ätzstopp (s. Fig. 4). Die strukturierte dritte Schicht 10 und die strukturierte zweite Schicht 9 bilden gemeinsame Flanken. Die strukturierte zweite Schicht 9 bildet gemeinsam mit der strukturierten dritten Schicht 10 eine erste Hilfsstruktur 12.

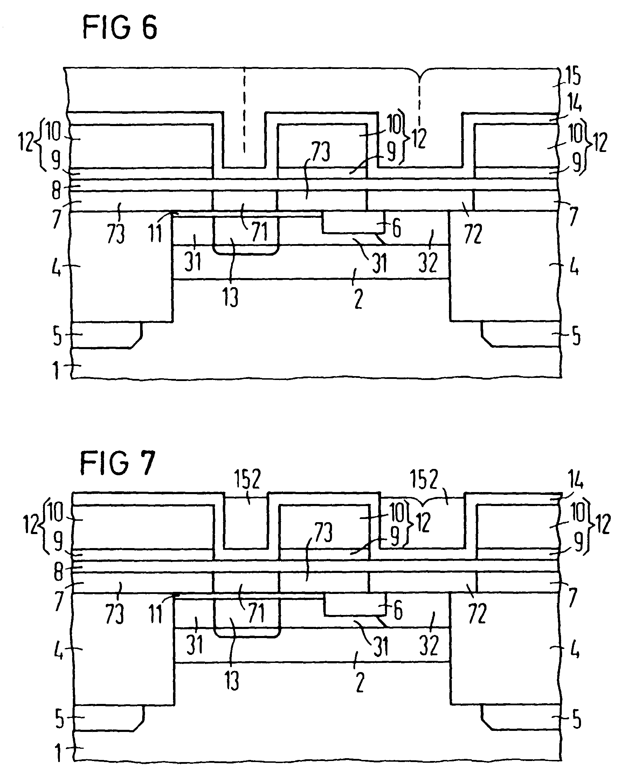

Durch eine Implantation von Donatoren, z. B. mit Arsen mit einer Dosis von 2 x 10¹⁶ cm⁻² und einer Energie von 80 keV, werden Bereiche der planaren Schicht 7 für einen Emitteranschluß 71 und einen Kollektoranschluß 72 dotiert (s. Fig. 5). Bereiche der planaren Schicht 7 für einen Basisanschluß 73 sind dabei durch die erste Hilfsstruktur 12 abgedeckt. Etwaige weitere Bereiche der planaren Schicht 7, die nicht durch die erste Hilfsstruktur 12 abgedeckt sind, müssen vor der Implantation mit Hilfe einer entsprechenden Photolackmaske abgeschirmt werden. Bei der Implantation wirkt die erste Schicht 8 als Streuoxid (screen oxide), um eine Verunreinigung der planaren Schicht 7 durch einen Neutralteilchenstrom, der bei der Implantation dem Ionenstrom beigemischt ist, zu vermeiden.

Durch eine zusätzliche, hochenergetische Implantation von Donatoren, z. B. Phosphor, wird unterhalb der Basiszone 11, selbstjustiert zu dem Emitteranschluß 71 in der Epitaxieinsel 31 ein Podestkollektor 13 erzeugt (s. Fig. 5). Der Podestkollektor 13 reicht bis in den vergrabenen Kollektor 2 hinein. Der Podestkollektor 13 verbessert den Kollektorwiderstand und führt damit zu einem Performance-Gewinn des fertigen Transistors (s. z. B. K. Ehinger et al, ESSDERC'89, pp. 797, Springer 1989). Bei der hochenergetischen Implantation werden die übrigen Bereiche abgeschirmt.

Nach der Implantation folgt eine Reinigung der Halbleiterscheibe. Auf der freiliegenden Oberfläche und auf den Flanken der ersten Hilfsstruktur 12 sowie auf der freiliegenden Oberfläche der ersten Schicht 8 wird konform eine erste Hilfsschicht 14 abgeschieden (s. Fig. 6). Die erste Hilfsschicht 14 ist selektiv sowohl zu der dritten Schicht 10 als auch zu der ersten Schicht 8 ätzbar. Die Dicke der ersten Hilfsschicht 14 ist vorzugsweise kleiner als ein Viertel des kleinsten Abstandes gegenüberliegender Flanken der ersten Hilfsstruktur 12. Die erste Hilfsschicht 14 besteht z. B. aus Polysilizium und weist eine Dicke von z. B. 50 nm auf. Auf die erste Hilfsschicht 14 wird eine zweite Hilfsschicht 15 abgeschieden. Die zweite Hilfsschicht 15 wird so abgeschieden, daß die über dem Emitteranschluß 71 und dem Kollektoranschluß 72 angeordneten Vertiefungen in der ersten Hilfsschicht 14 vollständig von der zweiten Hilfsschicht 15 aufgefüllt werden. Dies wird z. B. durch eine möglichst konforme Abscheidung der zweiten Hilfsschicht 15 erzielt wobei die Dicke der zweiten Hilfsschicht 15 vorzugsweise größer als die Differenz zwischen der Hälfte des größten Abstandes gegenüberliegender Flanken der ersten Hilfsstruktur 12 und der Dicke der ersten Hilfsschicht 14 ist. Die zweite Hilfsschicht 15 besteht z. B. aus Siliziumoxid. Eine andere Möglichkeit die Vertiefungen in der Oberfläche der ersten Hilfsschicht 14 auszufüllen, besteht darin, als zweite Hilfsschicht 15 ein planarisierendes Bor-Phosphor-Silikatglas zu verwenden.

Das Material der zweiten Hilfsschicht 15 wird so gewählt, daß sie selektiv zur ersten Hilfsschicht 14 ätzbar ist (s. Fig. 6).

Anschließend wird die zweite Hilfsschicht 15 anisotrop rückgeätzt, so daß die Oberfläche der ersten Hilfsschicht 14 im Bereich oberhalb des Basisanschlusses 73 freigelegt wird. Im Bereich oberhalb des Emitteranschlusses 71 und oberhalb des Kollektoranschlusses 72 verbleiben dabei pfropfenförmige Ätzreste 152 (plugs) (s. Fig. 7).

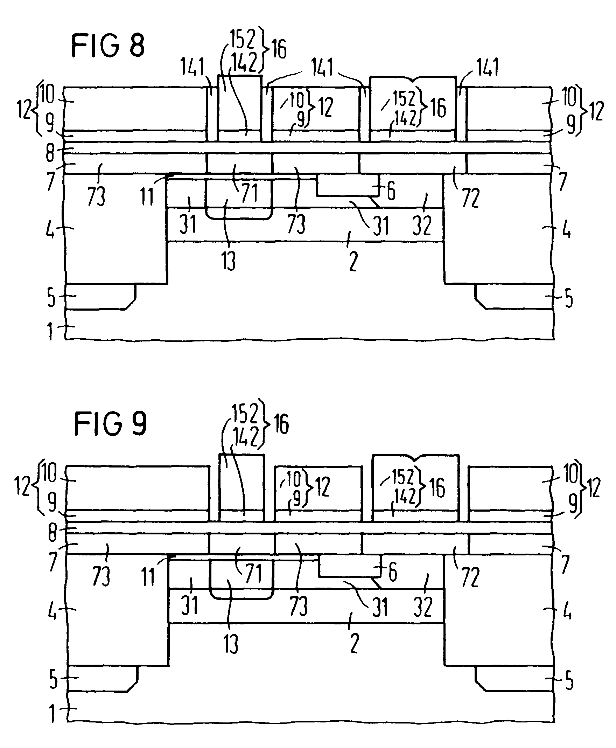

Anschließend wird die erste Hilfsschicht 14 anisotrop rückgeätzt. Dies erfolgt z. B. in zwei Teilschritten, wobei in einem ersten Teilschritt die freiliegende Oberfläche der ersten Hilfsschicht 14 entfernt wird (s. Fig. 8). Dabei wirkt die Oberfläche der ersten Hilfsstruktur 12 als Ätzstopp. Von der ersten Hilfsschicht bleiben nach diesem ersten Teilschritt senkrechte Anteile 141 bestehen, die zwischen der ersten Hilfsstruktur 12 und den Ätzresten 152 angeordnet sind, und abgedeckte Anteile 142, die zwischen den Ätzresten 152 und der ersten Schicht 8 angeordnet sind.

In einem zweiten Teilschritt werden die senkrechten Anteile 141 der ersten Hilfsschicht 14 durch anisotropes Ätzen entfernt. Dabei wirkt die Oberfläche der ersten Schicht 8 als Ätzstopp (s. Fig. 9). Dabei wird eine zweite Hilfsstruktur 16 aus den Ätzresten 152 und den darunterliegenden, abgedeckten Anteilen 142 der ersten Hilfsschicht 14 gebildet. Die zweite Hilfsstruktur 16 ist selbstjustiert zur ersten Hilfsstruktur 12 angeordnet. Der Abstand zwischen der ersten Hilfsstruktur 12 und den jeweils benachbarten Anteilen der zweiten Hilfsstruktur 16 ist nur durch die Breite der weggeätzten senkrechten Anteile 141 der ersten Hilfsschicht 14 definiert. Damit hängt dieser Abstand nur von der Dicke der konform abgeschiedenen ersten Hilfsschicht 14 ab.

Im folgenden werden die erste Hilfsstruktur 12 die zweite Hilfsstruktur 16 gemeinsam als Ätzmaske zur Strukturierung der planaren Schicht 7 verwendet. Dabei entstehen der Basisanschluß 73, der Emitteranschluß 71 und Kollektoranschluß 72. Die zweite Hilfsstruktur 16 bedeckt dabei den Emitteranschluß 71 und den Kollektoranschluß 72, während die erste Hilfsstruktur 12 den Basisanschluß 73 abdeckt. Der Abstand zwischen der ersten Hilfsstruktur 12 und der zweiten Hilfsstruktur 16 stellt daher den Abstand zwischen Basisanschluß 73 und Emitteranschluß 71 dar. Dieser Abstand ist daher nach den obigen Ausführungen nur über die Dicke der ersten Hilfsschicht 14 eingestellt. Die Dicke der ersten Hilfsschicht 14 kann im Bereich von 500 - 10 nm mit einer Genauigkeit von 3% - 5% erzeugt werden.

Aufgrund des Herstellverfahrens für die erste Hilfsstruktur 12 und die zweite Hilfsstruktur 16 ist sichergestellt, daß die durch das Wegätzen der senkrechten Anteile 141 gebildeten Lücken zwischen der ersten Hilfsstruktur 12 und der zweiten Hilfsstruktur 16 an den Rändern des Emitteranschlusses 71 und des Kollektoranschlusses 72 angeordnet sind. Bei Verwendung der ersten Hilfsstruktur 12 und der zweiten Hilfsstruktur 16 als Ätzmaske zur Strukturierung der planaren Schicht wird daher die planare Schicht 7 an den Rändern des Emitteranschlusses 71 und des Kollektoranschlusses 72 durchtrennt.

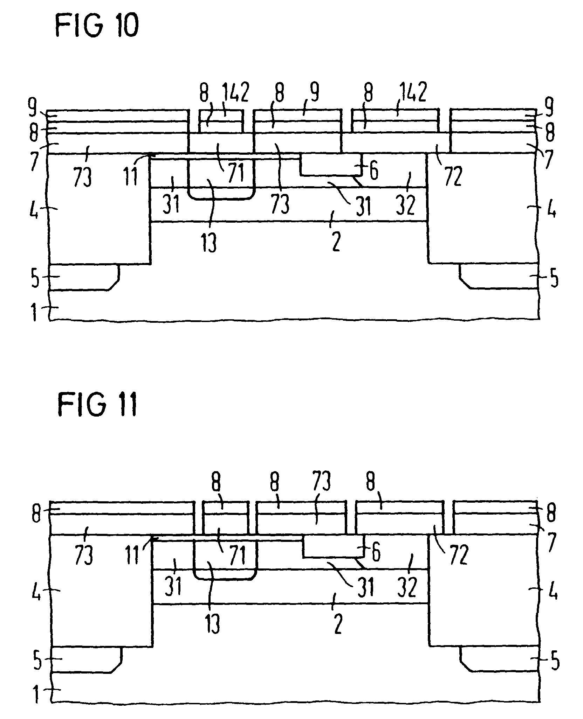

Es folgt eine anisotrope Ätzung, bei der das freiliegende Siliziumoxid, d. h. die Ätzreste 152, die strukturierte dritte Schicht 10 und die freiliegenden Teile der ersten Schicht 8, entfernt werden (s. Fig 10).

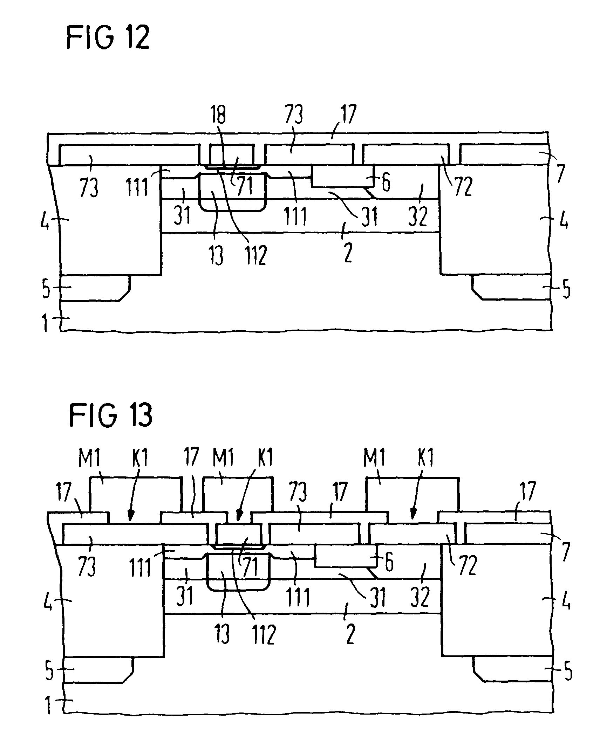

Es folgt eine anisotrope Ätzung der zweiten Schicht 9, die aus Polysilizium besteht, der nun freiliegenden, abgedeckten Anteile 142 der ersten Hilfsschicht 14, die aus Polysilizium besteht, sowie der freiliegenden Anteile der planaren Schicht 7, die ebenfalls aus Polysilizum besteht. Dabei wird die zweite Schicht 9 und die abgedeckten Anteile 142 vollständig entfernt, während die planare Schicht 7 bis zur Oberfläche der Basiszone 11 bzw. der Oxidinsel 6 bzw. des Isolationsbereichs 4 durchtrennt wird (s. Fig. 11). Im Interesse einer besseren Endpunktkontrolle auf der Basiszone 11 ist es vorteilhaft, zunächst die großflächigen Anteile der zweiten Schicht 9 und die abgedeckten Anteile 142 zu entfernen, wobei die erste Schicht 8 aus Siliziumoxid als Ätzstopp wirkt. Danach wird mit einer genau definierten Überätzung die planare Schicht 7 vollständig durchtrennt. Dabei entstehen der Emitteranschluß 71, der Kollektoranschluß 72 und der Basisanschluß 73. Bei der Strukturierung der planaren Schicht 7 können außerhalb des Bipolartransistors weitere Schaltelemente wie z. B. Widerstände oder Leitbahnen aus der planaren Schicht 7 strukturiert werden.

Da die Lücken zwischen der ersten Hilfsstruktur 12 und der zweiten Hilfsstruktur 16 herstellungsgemäß an den Rändern des Emitteranschlusses 71 und des Kollektoranschlusses 73 liegen, ist der gebildete Basisanschluß 73 p-dotiert und die gebildeten Emitteranschluß 71 und Kollektoranschluß 72 n-dotiert. Eine etwaige Ausdiffusion von Donatoren aus dem Bereich des Emitteranschlusses 71 und des Kollektoranschlusses 73 vor der Strukturierung der planaren Schicht 7 in den Bereich des Basisanschlusses 73 wird von der in diesen Bereichen herrschenden Akzeptor-Dotierung kompensiert.

Es wird ganzflächig eine Oxidschicht 17 abgeschieden, so daß die Spalte zwischen Basisanschluß 73, Emitteranschluß 71 und Kollektoranschluß 72 geschlossen werden (s. Fig. 12). Dabei umfaßt die Oxidschicht 17 auch die Reste der ersten Schicht 8. Es folgt ein Hochtemperaturschritt z. B. 10 sec. bei 1050°C mit Hilfe schneller optischer Ausheilung (ROA) oder 10 min. lang bei 900°C mit Hilfe einer Ofentemperung. Dabei wird eine Emitterzone 18 durch Ausdiffusion von Donatoren aus dem Emitteranschluß 71 gebildet. Dabei wird ebenfalls eine inaktive Basis 111 durch Ausdiffusion aus dem Basisanschluß 73 gebildet. Eine aktive Basiszone 112 entsteht zwischen der Emitterzone 18 und dem Podestkollektor 13 (s. Fig. 12).

Durch Öffnen von Kontaktlöchern der Oxidschicht 17 oberhalb des Emitteranschlusses 71, des Kollektoranschlusses 72 und des Basisanschlusses 73 und durch Metallisierung der Kontaktlöcher in bekannter Weise wird der Bipolartransistor fertiggestellt (s. Fig. 13).

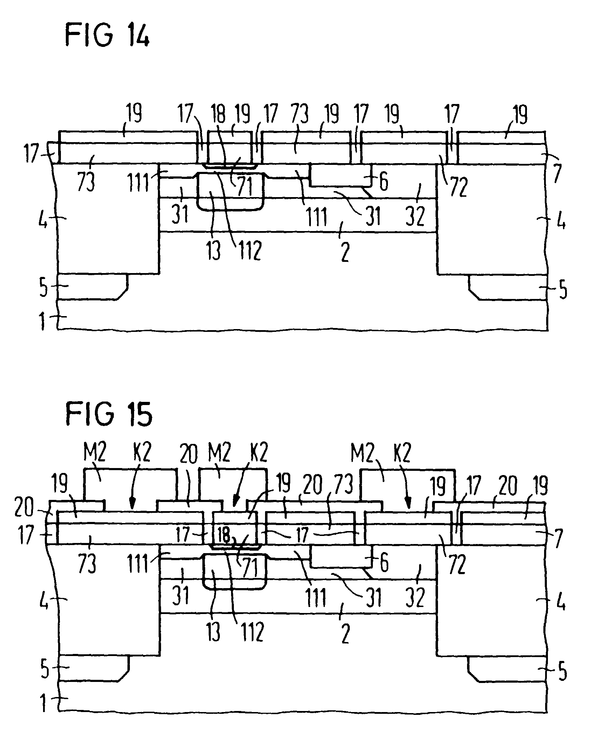

In einer weiteren Ausführungsform wird die Oxidschicht 17 zunächst in einem Rückätzschritt, z. B. mit Hilfe von reaktiven Ionenätzen soweit entfernt, daß die Oberfläche des Basisanschlusses 73, des Emitteranschlusses 71 und des Kollektoranschlusses 72 freiliegt. Diese freiliegenden Bereiche können mit Hilfe einer Salicide-Technik siliziert werden. Dies erfolgt z. B. durch Aufbringen von Platin oder Titan, anschließender Silizierung und Entfernung der nicht reagierten metallischen Komponente. Dadurch wird selektiv auf dem Basisanschluß 73, dem Emitteranschluß 71 und dem Kollektoranschluß 72 eine gutleitende Schicht 19 erzeugt (s. Fig. 14). Die leitende Schicht 19 kann auch durch eine CVD-Abscheidung von Wolfram oder eine CVD-Abscheidung von WSiₓ erzeugt werden.

Ein Vorteil dieser Variante ist, daß die Silizide keinem Hochtemperaturschritt mehr unterworfen werden und daher eine Immobilisierung von Dotierstoffen durch Compoundbildung im Silizid oder Segregation nicht mehr stattfinden kann.

Abschließend wird die Struktur mit einer Passivierungsschicht 20 aus z. B. Oxid abgedeckt. In der Passivierungsschicht 20 werden z. B. durch reaktives Ionenätzen Kontaktlöcher K2 geöffnet, die mit einer Metallisierung M2 versehen werden. Als Metallisierung M2 sind z. B. PtSi/TiW/Al (Si, Cu), TiN/Al(Si, Cu) oder W/Al (Si, Cu) geeignet. Der fertige Bipolartransistor ist in Fig. 15 dargestellt.

Die planare Schicht 7 kann anstelle von aus dotiertem Polysilizium auch aus einem dotierten Silizid, das den temperaturschritt zum Austreiben der Emitterzone 18 verträgt, z. B. WSiₓ oder aus einer Schichtenkombination dotiertes Polysilizium, Diffusionsbarriereschicht z. B. TiN, Silizid stehen.

Die erste Schicht 8, zweite Schicht 9, dritte Schicht 10, erste Hilfsschicht 14, zweite Hilfsschicht 15 können an Stelle der angegebenen Materialien aus anderen, gegenseitig selektiv ätzbaren Materialien bestehen.

Das für eine npn-Transistor beschriebene Herstellverfahren ist ohne weiteres auf einen pnp-Transistor übertragbar.

Der elektrische Widerstand des Basisanschlusses 73 aus dotiertem Polysilizium kann durch eine zusätzliche Implantation von Akzeptoren, z. B. Bor verringert werden. Bei dieser Implantation wird eine unkritische phototechnisch erzeugte Maske verwendet, um n-dotierte Bereiche der planaren Schicht 7 abzuschirmen. Dieser Schritt wird nach der Strukturierung der planaren Schicht 7 und vor dem Hochtemperaturschritt zur Erzeugung der Emitterzone 18 durchgeführt.

## Patentansprüche

1. Verfahren zur Herstellung eines Bipolartransistors mit folgenden Schritten:
a) auf einem Substrat (1) wird ganzflächig eine planare Schicht (7) erzeugt, die von einem ersten Leitfähigkeitstyp dotiert ist,
b) auf der planaren Schicht (7) wird eine erste Hilfsstruktur (12) erzeugt, die selektiv zur planaren Schicht (7) ätzbar ist und die einen Bereich der planaren Schicht (7) für einen Basisanschluß (73) abdeckt, während sie Bereiche der planaren Schicht (7) für einen Emitteranschluß (71) und einen Kollektoranschluß (72) definiert,
c) unter Verwendung der ersten Hilfsstruktur (12) als Implantationsmaske werden die Bereiche für den Emitteranschluß (71) und für den Kollektoranschluß (72) durch Ionenimplantation von einem zweiten Leitfähigkeitstyp dotiert, der entgegengesetzt zu dem ersten Leitfähigkeitstyp ist,
d) auf die erste Hilfsstruktur (12) und die freiliegenden Bereiche der planaren Schicht (7) wird ganzflächig und konform eine erste Hilfsschicht (14) abgeschieden, die selektiv zur ersten Hilfsstruktur (12) und zur planaren Schicht (7) ätzbar ist und deren Dicke so bestimmt ist, daß die Oberfläche der ersten Hilfsschicht (14) Vertiefungen aufweist, die die Form der ersten Hilfsstruktur (12) wiederspiegeln,
e) auf der ersten Hilfsschicht (14) wird eine zweite Hilfsschicht (15) erzeugt, die selektiv zur ersten Hilfsschicht (14) ätzbar ist, die die Oberfläche der ersten Hilfsschicht (14) vollständig bedeckt und mit der die Vertiefungen in der Oberfläche der ersten Hilfsschicht (14) vollständig ausgefüllt werden,
f) durch Rückätzen der zweiten Hilfsschicht bis zum Freilegen der Oberfläche der ersten Hilfsschicht (14) außerhalb der Vertiefungen und durch anschließendes Rückätzen der freiliegenden Teile der ersten Hilfsschicht (14) bis auf die darunterliegende Oberfläche der planaren Schicht (7) wird selbstjustiert zur ersten Hilfsstruktur (12) eine zweite Hilfsstruktur (16) erzeugt, die die Bereiche für den Emitteranschluß (71) und den Kollektoranschluß (72) abdeckt und die selektiv zur planaren Schicht (7) ätzbar ist,
g) die erste Hilfsstruktur (12) wird gemeinsam mit der zweiten Hilfsstruktur (16) als Ätzmaske verwendet, um durch Strukturierung der planaren Schicht (7) den Basisanschluß (73), den Emitteranschluß (71) und den Kollektoranschluß (72) zu erzeugen.

2. Verfahren nach Anspruch 1,
**dadurch gekennzeichnet**,
daß die zweite Hilfsschicht (15) ganzflächig und konform abgeschieden wird in einer Dicke größer als die Differenz zwischen der Hälfte des größten Abstandes gegenüberliegender Flanken der ersten Hilfsstruktur (12) und der Dicke der ersten Hilfsschicht (14).

3. Verfahren nach Anspruch 1 oder 2,
**dadurch gekennzeichnet**,
daß die Dicke der ersten Hilfsschicht (14) kleiner als ein Viertel des kleinsten Abstandes gegenüberliegender Flanken der ersten Hilfsstruktur (12) ist.

4. Verfahren nach einem der Ansprüche 1 bis 3,
**dadurch gekennzeichnet**,
daß auf die planare Schicht (7) vor der Erzeugung der ersten Hilfsstruktur (12) eine erste Schicht (8) aufgebracht wird, die selektiv zur planaren Schicht (7) und zur ersten Hilfsstruktur (12) ätzbar ist und die so ausgewählt ist, daß die Implantation in die vorgegebenen Bereiche der planaren Schicht (7) für den Emitteranschluß (71) und den Kollektoranschluß (72) durch die erste Schicht (8) hindurch erfolgt.

5. Verfahren nach Anspruch 4,
**gekennzeichnet durch** folgende Schritte:
a) auf die erste Schicht (8) wird eine zweite Schicht (9) und auf die zweite Schicht (9) eine dritte Schicht (10) aufgebracht, wobei benachbarte Schichten jeweils selektiv zueinander ätzbar sind,
b) die erste Hilfsstruktur (12) wird nach phototechnischer Definition durch anisotropes Rückätzen der dritten Schicht (10) und der zweiten Schicht (9) erzeugt.

6. Verfahren nach Anspruch 5,
**dadurch gekennzeichnet**,
daß die planare Schicht (7), die zweite Schicht (9) und die erste Hilfsschicht (14) aus Polysilizium und die zweite Hilfsschicht (15), die erste Schicht (8) und die dritte Schicht (10) aus Siliziumoxid bestehen.

7. Verfahren nach Anspruch 6,
**gekennzeichnet durch** folgende Schritte:
a) zur Strukturierung der planaren Schicht (7) werden zunächst die Reste der zweiten Hilfsschicht (152) selektiv zur darunterliegenden ersten Hilfsschicht (142), die Reste der dritten Schicht (10) selektiv zur darunterliegenden zweiten Schicht (9) und die freiliegenden Bereiche der ersten Schicht (8) selektiv zur darunterliegenden planaren Schicht (7) in einem anisotropen Ätzprozeß entfernt,
b) anschließend werden die Reste der ersten Hilfsschicht (14) und der zweiten Schicht (9) jeweils selektiv zur darunterliegenden ersten Schicht (8) und die freiliegenden Bereiche der planaren Schicht (7) bis auf die Oberfläche des Substrats (1) in einem anisotropen Ätzprozeß entfernt.

8. Verfahren nach einem der Ansprüche 1 bis 7,
**dadurch gekennzeichnet**,
daß vor dem Erzeugen der planaren Schicht (8) auf dem Substrat (1) durch epitaktische Abscheidung eine vom ersten Leitfähigkeitstyp dotierte Basiszone (11) und darauf eine vom zweiten Leitfähigkeitstyp dotierte Emitterzone (18) erzeugt werden.

9. Verfahren nach Anspruch 8,
**dadurch gekennzeichnet**,
daß mindestens eine der Basiszone (11) und der Emitterzone (18) aus Si₁₋ₓGeₓ mit 0,1 ≤ x ≤ 0,3 besteht.

10. Verfahren nach einem der Ansprüche 1 bis 7,
**dadurch gekennzeichnet**,
daß vor dem Erzeugen der ersten Hilfsstruktur (12) durch Ausdiffusion aus der planaren Schicht (7) im Substrat (1) eine vom ersten Leitfähigkeitstyp dotierte Basiszone (11) gebildet wird.

11. Verfahren nach einem der Ansprüche 1 bis 10,
**dadurch gekennzeichnet**,
daß nach der Implantation für die für den Emitteranschluß (71) und den Kollektoranschluß (72) vorgegebenen Bereiche der planaren Schicht (7) unter Verwendung der ersten Hilfsstruktur (12) als Implantationsmaske eine zusätzliche, hochenergetische Implantation von Dotierstoff vom zweiten Leitfähigkeitstyp zur Erzeugung eines Podest-Kollektors (13) unterhalb der Basiszone (11) im Substrat (1) durchgeführt wird.

## Claims

1. Method for producing a bipolar transistor, having the following steps:
a) a planar layer (7) is produced over the whole area on a substrate (1), which planar layer is doped by a first conductivity type,
b) a first auxiliary structure (12) is produced on the planar layer (7), which first auxiliary structure can be etched selectively with respect to the planar layer (7) and covers a region of the planar layer (7) for a base terminal (73), while the said first auxiliary structure defines regions of the planar layer (7) for an emitter terminal (71) and a collector terminal (72),
c) using the first auxiliary structure (12) as an implantation mask, the regions for the emitter terminal (71) and for the collector terminal (72) are doped, by ion implantation, by a second conductivity type which is opposite to the first conductivity type,
d) a first auxiliary layer (14) is conformally deposited over the whole area onto the first auxiliary structure (12) and the exposed regions of the planar layer (7), which first auxiliary layer can be etched selectively with respect to the first auxiliary structure (12) and with respect to the planar layer (7) and the thickness of which auxiliary layer is determined such that the surface of the first auxiliary layer (14) has depressions which reflect the form of the first auxiliary structure (12),
e) a second auxiliary layer (15) is produced on the first auxiliary layer (14), which second auxiliary layer can be etched selectively with respect to the first auxiliary layer (14) and completely covers the surface of the first auxiliary layer (14), the depressions in the surface of the first auxiliary layer (14) being completely filled by the said second auxiliary layer,
f) a second auxiliary structure (16) is produced in a self-aligned manner with respect to the first auxiliary structure (12) by etching back the second auxiliary layer to expose the surface of the first auxiliary layer (14) outside the depressions and by subsequently etching back the exposed parts of the first auxiliary layer (14) down to the surface of the planar layer (7) lying underneath, which second auxiliary structure covers the regions for the emitter terminal (71) and the collector terminal (72) and can be etched selectively with respect to the planar layer (7),
g) the first auxiliary structure (12) is used together with the second auxiliary structure (16) as an etching mask to produce the base terminal (73), the emitter terminal (71) and the collector terminal (72) by structuring the planar layer (7).

2. Method according to Claim 1, characterized in that the second auxiliary layer (15) is conformally deposited over the whole area to a thickness which is greater than the difference between half the largest distance between opposite flanks of the first auxiliary structure (12) and the thickness of the first auxiliary layer (14).

3. Method according to Claim 1 or 2, characterized in that the thickness of the first auxiliary layer (14) is less than one quarter of the smallest distance between opposite flanks of the first auxiliary structure (12).

4. Method according to one of Claims 1 to 3, characterized in that a first layer (8) is applied to the planar layer (7) prior to the production of the first auxiliary structure (12), which first layer can be etched selectively with respect to the planar layer (7) and with respect to the first auxiliary structure (12) and is selected in such a way that the implantation into the predetermined regions of the planar layer (7) for the emitter terminal (71) and the collector terminal (72) takes place through the first layer (8).

5. Method according to Claim 4, characterized by the following steps:
a) a second layer (9) is applied to the first layer (8) and a third layer (10) is applied to the second' layer (9), adjacent layers in each case able to be etched selectively with respect to one another,
b) the first auxiliary structure (12) is produced, after photographic definition, by anisotropic etching back of the third layer (10) and of the second layer (9).

6. Method according to Claim 5, characterized in that the planar layer (7), the second layer (9) and the first auxiliary layer (14) are composed of polysilicon and the second auxiliary layer (15), the first layer (8) and the third layer (10) are composed of silicon oxide.

7. Method according to Claim 6, characterized by the following steps:
a) in order to structure the planar layer (7), first of all the residues of the second auxiliary layer (152) are removed selectively with respect to the first auxiliary layer (142) lying underneath, the residues of the third layer (10) are removed selectively with respect to the second layer (9) lying underneath and the exposed regions of the first layer (8) are removed selectively with respect to the planar layer (7) lying underneath, in an anisotropic etching process,
b) afterwards the residues of the first auxiliary layer (14) and of the second layer (9) are removed in each case selectively with respect to the first layer (8) lying underneath and the exposed regions of the planar layer (7) are removed down to the surface of the substrate (1), in an anisotropic etching process.

8. Method according to one of Claims 1 to 7, characterized in that prior to the production of the planar layer (7), a base zone (11) which is doped by the first conductivity type and, on top of the said base zone, an emitter zone (18) which is doped by the second conductivity type are produced on the substrate (1) by means of epitaxial deposition.

9. Method according to Claim 8, characterized in that at least one of the base zone (11) and the emitter zone (18) is composed of Si₁₋ₓGeₓ, where 0.1 ≤ x ≤ 0.3.

10. Method according to one of Claims 1 to 7, characterized in that prior to the production of the first auxiliary structure (12), a base zone (11) which is doped by the first conductivity type is formed in the substrate (1) by means of outdiffusion from the planar layer (7).

11. Method according to one of Claims 1 to 10, characterized in that after the implantation for the regions of the planar layer (7) which are predetermined for the emitter terminal (71) and the collector terminal (72), using the first auxiliary structure (12) as an implantation mask, an additional, high-energy implantation of dopant of the second conductivity type is carried out in order to produce a pedestal collector (13) underneath the base zone (11) in the substrate (1).

## Revendications

1. Procédé de fabrication d'un transistor bipolaire, comportant les étapes suivantes:
a) sur un substrat (1), une couche planar (7), qui est dopée par un premier type de conductibilité, est réalisée sur toute la surface,
b) sur la couche planar (7), est réalisée une première structure auxiliaire (12) qui peut être décapée de façon sélective par rapport à la couche planar (7) et qui recouvre une zone de la couche planar (7) destinée à une connexion de base (73), tandis qu'elle définit des zones de la couche planar (7) destinées à une connexion d'émetteur (71) et à une connexion de collecteur (72),
c) en utilisant la première structure auxiliaire (12) comme masque d'implantation, les zones destinées à la connexion d'émetteur (71) et à la connexion de collecteur (72) sont dopées par implantation d'ions d'un deuxième type de conductibilité, inverse par rapport au premier type de conductibilité,
d) sur la première structure auxiliaire (12) et sur les zones mises à découvert de la couche planar (7), est déposée, sur toute la surface et de façon conforme, une première couche auxiliaire (14), qui peut être décapée de façon sélective par rapport à la première structure auxiliaire (12) et par rapport à la couche planar (7) et dont l'épaisseur est déterminée de telle façon que la surface supérieure de la première couche auxiliaire (14) présente des creux qui reflètent la forme de la première structure auxiliaire (12),
e) sur la première couche auxiliaire (14), est réalisée une deuxième couche auxiliaire (15) qui peut être décapée de façon sélective par rapport à la première couche auxiliaire (14), cette deuxième couche auxiliaire (15) recouvrant complètement la surface supérieure de la première couche auxiliaire (14) et remplissant complètement les creux situés dans la surface supérieure de la première couche auxiliaire (14),
f) en redécapant la deuxième couche auxiliaire jusqu'à la mise à découvert de la surface supérieure de la première couche auxiliaire (14), à l'exception des creux, puis en redécapant ensuite les parties mises à nu de la première couche auxiliaire (14) jusque sur la surface supérieure, située en dessous, de la couche planar (7), une deuxième structure auxiliaire (16) est réalisée avec auto-ajustement par rapport à la première structure auxiliaire (12), cette deuxième structure auxiliaire (16) recouvrant les zones destinées à la connexion d'émetteur (71) et à la connexion de collecteur (72), et pouvant être décapée de façon sélective par rapport à la couche planar (7).
g) la première structure auxiliaire (12) est utilisée en commun avec la deuxième structure auxiliaire (16) comme masque de décapage pour, par une structuration de la couche planar (7), réaliser la connexion de base (73), la connexion d'émetteur (71) et la connexion de collecteur (72).

2. Procédé suivant la revendication 1, caractérisé en ce que la deuxième couche auxiliaire (15) est déposée sur toute la surface et de façon conforme, en présentant une épaisseur plus grande que la différence entre la moitié de la plus grande distance entre flancs, se faisant face, de la première structure auxiliaire (12), et l'épaisseur de la première couche auxiliaire (14).

3. Procédé suivant la revendication 1 ou la revendication 2, caractérisé en ce que l'épaisseur de la première couche auxiliaire (14) est plus petite que le quart de la plus petite distance entre flancs, se faisant face, de la première structure auxiliaire (12).

4. Procédé suivant l'une des revendications 1 à 3, caractérisé en ce que, sur la couche planar (7), avant la réalisation de la première structure auxiliaire (12), est appliquée une première couche (8), qui peut être décapée de façon sélective par rapport à la couche planar (7) et par rapport à la première structure auxiliaire (12), et qui est choisie de telle façon que l'implantation dans les zones prédéfinies de la couche planar (7), destinées à la connexion d'émetteur (71) et à la connexion de collecteur (72), se fasse au travers de la première couche (8).

5. Procédé suivant la revendication 4, caractérisé par les étapes suivantes:
a) sur la première couche (8), est appliquée une deuxième couche (9), et sur la deuxième couche (9) est appliquée une troisième couche (10), les couches voisines pouvant être décapées chacune de façon sélective l'une par rapport à l'autre.
b) la première structure auxiliaire (12) est réalisée d'après une définition photographique, par redécapage anisotrope de la troisième couche (10) et de la deuxième couche (9).

6. Procédé suivant la revendication 5, caractérisé en ce que la couche planar (7), la deuxième couche (9) et la première couche auxiliaire (14) sont constituées de polysilicium et la deuxième couche auxiliaire (15), la première couche (8) et la troisième couche (10) sont constituées d'oxyde de silicium.

7. Procédé suivant la revendication 6, caractérisé par les étapes suivantes:
a) pour structurer la couche planar (7), sont d'abord éliminés, au cours d'une étape de décapage anisotrope, les restes de la deuxième couche auxiliaire (152), sélectivement par rapport à la première couche auxiliaire se trouvant en-dessous (142), les restes de la troisième couche (10) sélectivement par rapport à la deuxième couche (9) se trouvant en-dessous, et les zones mises à découvert de la première couche (8), sélectivement par rapport à la couche planar (7) placée en dessous,
b) ensuite les restes de la première couche auxiliaire (14) et de la deuxième couche (9) sont enlevés, au cours d'une opération de décapage anisotrope, chacun sélectivement par rapport à la première couche (8) se trouvant en-dessous, et les zones mises à découvert de la couche planar (7) jusqu'à la surface supérieure du substrat (1).

8. Procédé suivant l'une des revendications 1 à 7, caractérisé en ce qu'avant la réalisation de la couche planar (8), est réalisée sur le substrat (1), par dépôt épitaxial, une zone de base (11) dopée avec un premier type de conductibilité et, au dessus, une zone d'émetteur (18), dopée avec un deuxième type de conductibilité.

9. Procédé suivant la revendication 8, caractérisé en ce qu'au moins l'une des zones de base (11) et d'émetteur (18) est constituée de Si₁₋ₓGeₓ avec 0,1 ≤ x ≤ 0,3.

10. Procédé suivant l'une des revendications 1 à 7, caractérisé en ce qu'avant la réalisation de la première structure auxiliaire (12), une zone de base (11) est formée par diffusion à partir de la couche planar (7) dans le substrat (1).

11. Procédé suivant l'une des revendications 1 à 10, caractérisé en ce qu'après l'implantation pour les zones de la couche planar (7), prédéfinies pour la connexion d'émetteur (71) et la connexion de collecteur (72), en utilisant la première structure auxiliaire (12) comme masque d'implantation, on effectue une implantation supplémentaire à haute énergie d'un produit de dopage du deuxième type de conductibilité pour réaliser un collecteur-plateforme (13) en dessous de la zone de base (11), dans le substrat (1).
